(19) **Europäisches Patentamt**

**European Patent Office**

**Office européen des brevets**

(11) **EP 1 224 739 B1**

(12) **EUROPÄISCHE PATENTSCHRIFT**

(45) Veröffentlichungstag und Bekanntmachung des Hinweises auf die Patenterteilung:
**18.06.2003 Patentblatt 2003/25**

(51) Int Cl.$^7$: **H03M 7/00**

(21) Anmeldenummer: **00982974.8**

(86) Internationale Anmeldenummer:
**PCT/DE00/03535**

(22) Anmeldetag: **06.10.2000**

(87) Internationale Veröffentlichungsnummer:
**WO 01/026234 (12.04.2001 Gazette 2001/15)**

(54) **SIGMA-DELTA-MODULATOR**

SIGMA DELTA MODULATOR

MODULATEUR SIGMA-DELTA

(84) Benannte Vertragsstaaten:
**DE FR GB**

(30) Priorität: **07.10.1999 DE 19948374**

(43) Veröffentlichungstag der Anmeldung:
**24.07.2002 Patentblatt 2002/30**

(73) Patentinhaber: **SIEMENS AKTIENGESELLSCHAFT**
**80333 München (DE)**

(72) Erfinder: **JELONNEK, Björn**
**89079 Ulm (DE)**

(56) Entgegenhaltungen:
**EP-A- 0 506 079      EP-A- 0 551 690**
**US-A- 5 870 048**

**Beschreibung**

Die Erfindung bezieht sich auf einen Sigma-Delta-Modulator nach den Merkmalen des Oberbegriffs des Anspruchs 1.

In Digital-Analog-Wandlern, wie sie zum Beispiel in digitalen Funkkommunikations-Einrichtungen eingesetzt werden, wird üblicherweise ein digitales Eingangssignal mit $2^n$ Signalzuständen und einer festen Abtastfrequenz $f_a$ in ein analoges Signal überführt, das im Frequenzbereich $-f_a/2$ bis $+f_a/2$ möglichst gut mit dem digitalen Signal übereinstimmen soll.

Insbesondere bei hohen Bitbreiten $n$ stellt die durch analoge Schaltungstechnik zu realisierende Anzahl von Signalzuständen ein wesentliches Problem dar. Aus diesem Grund wird ein digitales Signal durch digitale Filter interpoliert, und es werden sogenannte Sigma-Delta-Modulatoren eingesetzt, die die Bitbreite $n$ eines digitalen Signals bei erhöhter Abtastfrequenz deutlich reduzieren und das dadurch erzeugte Quantisierungsrauschen in bisher ungenutzte Frequenzbereiche transformieren. Besonders effizient sind hierbei Strukturen, die eine Rauschformung erzielen, die mit einer durch IIR-Filter (Infinite Impulse Response-Filter) höherer Ordnung erzielbaren Formung vergleichbar sind.

Bei den Sigma-Delta-Modulatoren existieren zwei Ansätze, um eine Rauschformung zu erreichen. Nach einem ersten Ansatz werden Rückkopplungsschleifen höherer Ordnung eingesetzt, was eine Reduktion auf bis zu zwei Signalzuständen erlaubt (1-Bit-Signaltechnik), jedoch ab einer Rauschformung der Ordnung 3 zu möglichen Instabilitäten bei hohen Eingangssignalen führt. Es treten sehr leicht Überhöhungen des Wertebereiches auf. Um dem zu begegnen, werden in der Praxis ein in der Amplitude verringertes Eingangssignal sowie Zustandsspeicher mit Clipping-Eigenschaften verwendet, wodurch sich eine empirisch ermittelte Stabilität der Schaltung erreichen läßt.

Nach einem weiteren Ansatz werden Strukturen erster und/oder zweiter Ordnung kaskadiert, die mehrstufig sind und dadurch ein stabiles Betriebsverhalten aufweisen.

Bekannte Strukturen von Sigma-Delta-Modulatoren arbeiten seriell und im hohen Takt, da es sich bei den Sigma-Delta-Modulatoren um rückgekoppelte Strukturen mit nichtlinearen Elementen handelt. Eine ausführliche Darstellung zur Theorie und zum Aufbau von Sigma-Delta-Modulatoren wird in S.R. Norswothy, R. Schreier, G. Temes: "Delta-Sigma Data Converters, Theory, Design and Simulation", IEEE Press 1997, ISBN 0-7803-1045-4 gegeben.

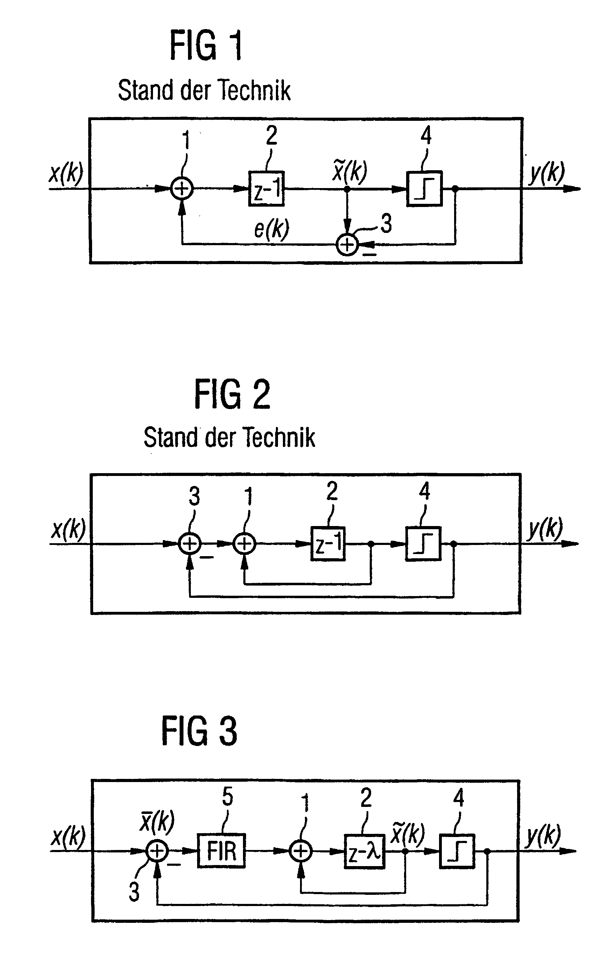

In US 5,870,048 zeigen die Figuren FIG 2a und FIG 2b Blockschaltdiagramme von kaskadierten Sigma-Delta-Modulatoranordnungen. Dabei wird in FIG 2b ein Eingangssignal X(z) an einen ersten Sigma-Delta-Modulator angeschaltet, der einerseits ein "first stage quantization noise Q1(z)"-Signal und andererseits ein digitales erstes Ausgangssignal erzeugt. Das "first stage quantization noise Q1(z)"-Signal gelangt als Eingangssignal an einen zweiten Sigma-Delta-Modulator, der mit Hilfe dieses Signals ein zweites Ausgangssignal erzeugt. Das zweite Ausgangssignal wird zurückgeführt und negiert auf auf das "first stage quantization noise Q1(z)"-Signal aufaddiert. Das erste und das zweite Ausgangssignal des ersten und des zweiten Sigma-Delta-Modulators werden zu einem Ausgangssignal Y(z) aufaddiert.

In EP 0 506 079 A1 zeigt die Figur FIG4 ein System, das aus mehreren parallel zueinander angeordneten Sigma-Delta-Wandlern besteht. Ein Eingangssignal "digital input" gelangt nach einer Signalvorverarbeitung an jeden einzelnen der Sigma-Delta-Wandler, die ohne gegenseitige Beeinflussung das Eingangssignal zu einem Ausgangssignal "analog output" weiterverarbeiten.

In EP 0 551 690 A1 zeigt Figur FIG9a ebenfalls eine parallele Anordnung von Sigma-Delta-Wandlern, die unabhängig voneinander ein analoges Eingangssignal "analog input" in ein digitales Ausgangssignal "digital output" weiterverarbeiten.

Aufgrund der angestrebten Rauschformung arbeitet der Sigma-Delta-Modulator eines typischen Digital-Analog-Wandlers zeitund wertediskret auf einer Taktfrequenz, die wesentlich höher als die maximal verwendete Signalfrequenz ist. Er besitzt rückgekoppelte Filter sowie nichtlineare Teilstrukturen, die eine Implementation dieser Strukturen in einem tieferen Takt verbieten.

Der Erfindung liegt die Aufgabe zugrunde, eine Struktur für einen Sigma-Delta-Modulator zu entwickeln, die im tieferen Takt und damit kostengünstiger und mit einer leistungssparenden Technologie arbeitet.

Die Aufgabe der Erfindung wird durch die Merkmale des Anspruchs 1 gelöst.

Dabei wird ein Sigma-Delta-Modulator mit mindestens zwei parallel zueinander angeordneten Zweigen realisiert. An jedem einzelnen der Zweige ist ein zu wandelndes digitales Eingangssignal angeschaltet. Dabei beinhaltet ein erster Zweig einen Sigma-Delta-Modulator erster Ordnung, dem das digitale Eingangssignal zeitdiskret abgetastet zur Bildung eines quantisierten Ausgangssignals zugeführt wird. Ein vom Sigma-Delta-Wandler erster Ordnung errechneter Quantisierungs-fehlerwert gelangt neben dem digitalen Eingangssignal an einen zweiten Zweig zur weiteren Verarbeitung.

Mit Hilfe des erfindungsgemäßen Sigma-Delta-Modulators kann auch ein Sigma-Delta-Modulator höherer Ordnung durch Kaskadierung realisiert werden.

Vorteilhafte Weiterbildungen der Erfindung geben die begleitenden Ansprüche an.

Mit der Erfindung wird erreicht, daß Sigma-Delta-Modulatoren im tieferen Abtasttakt und damit mit weniger schaltungstechnischem Aufwand und kostengünstiger realisiert werden können.

Anhand eines Ausführungsbeispiels soll die Erfindung näher erläutert werden. In der zugehörigen Zeichnung zeigen:

Fig. 1 einen Sigma-Delta-Modulator 1. Ordnung nach dem bekannten Stande der Technik,

Fig. 2 eine Abwandlung des Sigma-Delta-Modulators 1. Ordnung nach Fig. 1,

Fig. 3 eine fortführende Abwandlung des Sigma-Delta-Modulators 1. Ordnung mit FIR- und IIR-Teilfiltern,

Fig. 4 eine fortführende Abwandlung nach Fig. 3 unter vertauschter Anordnung des FIR-Filters (Teilfilter FIR1, FIR2) mit dem Addierer am Eingang des Sigma-Delta-Modulators 1. Ordnung,

Fig. 5 eine fortführende Abwandlung nach Fig. 4 unter Zusammenfassung der Ausgangssignale vom IIR- und FIR2-Filter,

Fig. 6 eine fortführende Abwandlung eines Sigma-Delta-Modulators 1. Ordnung nach Fig. 5 unter Kombination des Teilfilters FIR2 und des Quantisierers zu einem Multibitquantisierer,

Fig. 7 eine fortführende Abwandlung eines Sigma-Delta-Modulators 1. Ordnung nach Fig. 6 unter Ersetzung des Teilfilters FIR1 durch ein Integrate&Dump-Filter,

Fig. 8 eine zur Berechnung fehlender Zustandswerte des Quantisierungsfehlers erweiterte Anordnung eines Sigma-Delta-Modulators 1. Ordnung nach Fig. 7,

Fig. 9 einen erfindungsgemäßer Aufbau eines parallel realisierten Sigma-Delta-Modulators 1. Ordnung,

Fig. 10 aus Fig. 9 herausgezeichnete Module,

Fig. 11 eine erfindungsgemäße Realisierung eines aus drei Stufen eines Sigma-Delta-Modulators 1. Ordnung kaskadierten Sigma-Delta-Modulators höherer Ordnung,

Fig. 12 einen Logik-Modul für die 1. Stufe eines Sigma-Delta-Modulators zur Ermittlung der Werte des Quantisierers aus dem Quantisierungsfehler und dem Eingangssignal und

Fig. 13 einen Logik-Modul für die 2. und folgenden Stufen eines Sigma-Delta-Modulators zur Ermittlung der Werte des Quantisierers aus dem Quantisierungsfehler und dem Eingangssignal.

Die vorliegende Erfindung geht von einem bekannten Sigma-Delta Modulator 1. Ordnung aus, wie er schematisiert in Fig. 1 dargestellt ist. Ohne Einschränkung der Allgemeinheit der Erfindung sei in der nachfolgenden Betrachtung das Eingangssignal $x(k)$ auf den Zahlenbereich $-1 \leq x(k) \leq 1$ normiert und die Stufenhöhe des Quantisierers als $2/(L-1)$ angenommen, wobei $L$ die Anzahl der Quantisierungsstufen angibt. Der digitale Sigma-Delta-Modulator wandelt das digitale Eingangssignal $x(k)$ in einen 3-stufigen (1.5-Bit)-Datenstrom als Ausgangssignal $y(k)$ um. Es sollte klar sein, daß jeder Typ von Quantisierer oder etwas Gleichwertiges verwendet werden kann, um die Konvertierung in einen quantisierten digitalen Datenstrom durchzuführen.

Das digitale Eingangssignal $x(k)$ wird in einen Addierer 1 gegeben, dessen Ausgang auf einen Verzögerer 2 geführt ist. Der Ausgang des Verzögerers 2 ist auf einen Addierer 3 und gleichzeitig auf den Eingang eines Entscheiders 4 geführt, in welchem das im Verzögerer 2 um eine Takteinheit gegenüber dem Signal $x(k)$ verzögerte Signal $\tilde{x}(k)$ in die spezifizierte Anzahl von Quantisierungsstufen, welche beim Beispiel auf den Satz (-1, 0, +1) beschränkt sind, quantisiert wird. Im Addierer 3 wird aus der Summe des Ausgangssignals $\tilde{x}(k)$ des Verzögerers 2 und dem negierten Ausgangssignal $y(k)$ des Entscheiders 4 aufgrund der Nichtlinearität des Quantisierers ein Quantisierungs-Fehlersignal $e(k)$ gebildet, das dem Addierer 1 am Eingang des Verzögerers 2 zwecks Autsummierung zum Eingangssignal $x(k)$ zugeführt wird.

Gemäß Fig. 2 wird der bekannte Sigma-Delta-Modulator 1. Ordnung nach Fig. 1 in einem ersten Schritt in ein IIR-Filter 1. Ordnung (Verzögerer 2, Addierer 1, Rückführungszweig), das als Integrator aufgefaßt werden kann, und einen Entscheider 4 überführt. IIR = Infinite Impulse Response-Filter (digitales Filter mit unendlicher Impulsantwort).

Das Eingangssignal $x(k)$, wird über den Integrator in den Entscheider 4 gespeist und das quantisierte Ausgangssignal *y(k)* wird zurück zum Eingang geführt, um vom Eingangssignal *x(k)* subtrahiert zu werden. Das um eine Takteinheit verzögerte Signal $\tilde{x}(k)$ wird direkt über einen Rückführungszweig auf den Addierer 1 geführt, dem außerdem die Differenz aus dem Eingangssignal *x(k)* und dem Ausgangssignal *y(k)* zugeführt wird, die in dem Addierer 3 gebildet wird.

Ein solcher Sigma-Delta-Modulator ist in der eingangs bezeichneten IEEE-Publikation S. 6 beschrieben und ebendort in Figure 1.4 als Blockdiagramm dargestellt.

In einem nächsten Schritt wird das IIR-Filter 1. Ordnung nach Fig. 2 in ein FIR-Filter 5 und ein IIR-Filter (Verzögerer 2, Addierer 1, Rückführzweig), das in einem tieferen Takt arbeitet, zerlegt. Gleichung (1) gibt an, wie sich die Übertragungscharakteristik des IIR-Filters in die zwei Teilfilter FIR und IIR zerlegen läßt:

$$\frac{1}{1-az^{-1}} = \left(\sum_{\nu=0}^{\lambda-1} a^{\nu} z^{-\nu}\right)\frac{1}{1-a^{\lambda}z^{-\lambda}} \; . \qquad (1)$$

mit $z = \exp(j\omega T)$,

$\alpha$ = Polstelle des IIR-Filters 1. Ordnung

$\lambda$ = Taktverhältnis von Ausgangs- zu Eingangstakt

Ein FIR-Filter (FIR = Finite Impulse Response-Filter) ist ein Filter mit endlicher Impulsantwort und zeichnet sich durch eine hohe Stabilität aus.

Im Falle eines Integrators, wie er in Fig. 2 verwendet wird, ist die Polstelle $\alpha=1$ und Gleichung (1) kann in Gleichung (2) überführt werden:

$$\frac{1}{1-z^{-1}} = \left(\sum_{\nu=0}^{\lambda-1} z^{-\nu}\right)\frac{1}{1-z^{-\lambda}} \; . \qquad (2)$$

Es ergibt sich eine Struktur nach Fig. 3 mit zwei Teilfiltern FIR und IIR. Das FIR-Filter 5 ist dabei zwischen den Addierern 3 und 1 angeordnet.

Bei dem gleichen Eingangssignal $\tilde{x}(k)$ der beiden Realisierungen des IIR-Filters erhält man auch das gleiche Ausgangssignal $\tilde{x}(k)$.

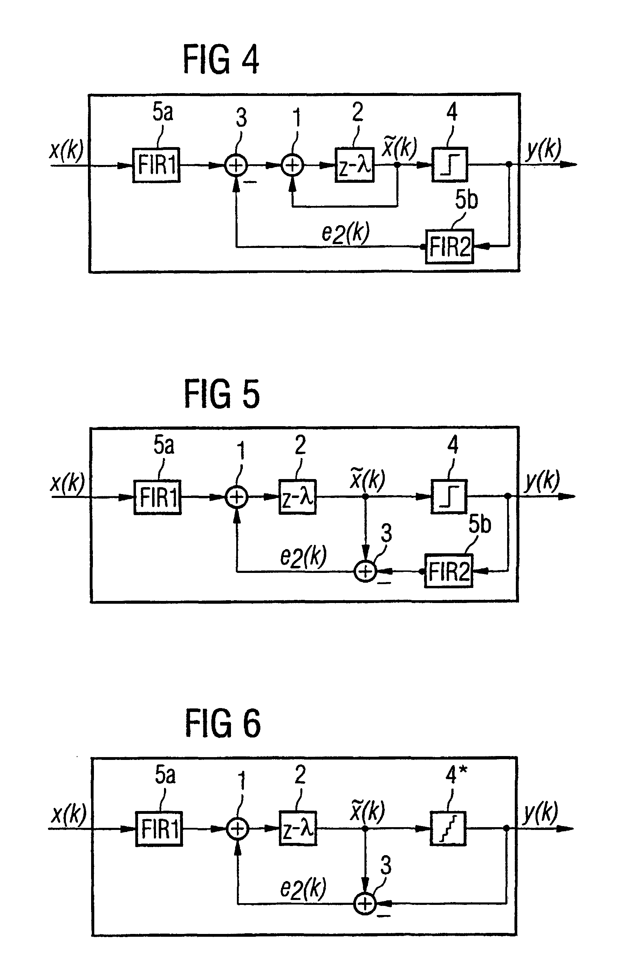

Die Verarbeitung der Werte im FIR-Filter 5 und die Addition im Addierer 3 sind lineare Operationen, weshalb das Filter 5 und der Addierer 3 vertauscht werden können. Dies ist in Fig. 4 dargestellt. Das FIR-Filter 5 ist dabei in zwei FIR-Teilfilter (FIR1, FIR2) 5a, 5b zerlegt, um auch den Zweig vom Ausgangssignal *y(k)* zum Addierer 3 funktionsgerecht einzubinden.

In einem nächsten Schritt werden die Ausgangssignale vom IIR-Filter (Verzögerer 2, Addierer 1, Rückführungszweig) und FIR2-Filter 5b gemäß Fig. 5 im Addierer 3 wieder zusammengefaßt.

In dem Filter FIR2 5b werden die letzten $\lambda$-1 Entscheiderausgangswerte addiert. Verwendet der Quantisierer *L* Stufen, so hat das Signal am Ausgang des Filters FIR2 5b $(L-1)\lambda+1$ Stufen. Man kann also die Kombination von FIR2 5b und Entscheider 4 als einen Multibit-Quantisierer 4* ansehen.

Entsprechend der oben durchgeführten Ableitung bilden FIR1-Filter 5a und IIR-Teilfilter (Verzögerer 2, Addierer 1, Rückführungszweig) in Fig. 6 einen Integrator nach, wie er in Fig. 1 verwendet wird. Von dem Integrationsergebnis wird in beiden Fällen ein Vielfaches der Quantisierungsstufe abgezogen. Da in der in Fig. 6 dargestellten Struktur wie in der in Fig. 1 dargestellten Struktur eines Sigma-Delta-Wandlers der Quantisierungsfehler auf den selben eindeutigen Bereich beschränkt ist, ist der Quantisierungsfehler der Strukturen von Fig. 1 und Fig. 6 identisch.

$$e_2(k)=e(k) \qquad\qquad (3)$$

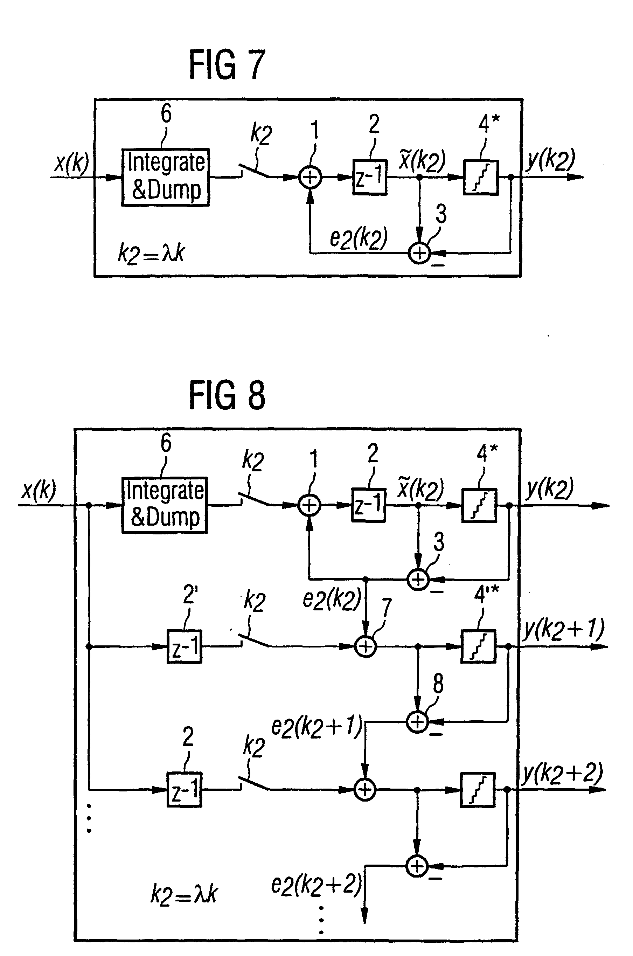

In der rückgekoppelten Teilstruktur von Fig. 6 wird eine Verzögerung um $\lambda$ Zeitpunkte durchgeführt. Will man nur unterabgetastet alle $\lambda$ Zeitpunkte die Quantisierungsfehlerwerte $e_2(k)$ bestimmen, so kann man die Berechnung im tiefen Takt durchführen: Das Teilfilter FIR1 5a wird durch ein Integrate&Dump-Filter 6 ersetzt und die Zeitverzögerung des tiefen Taktes verwendet. Dies ist in Fig. 7 veranschaulicht.

Mit dem gemäß Fig. 8 weiterentwickelten Sigma-Delta-Modulator erhält man Stützstellen für die Zustandswerte eines auf hohem Takt (Taktrate $k_2=\lambda k$) arbeitenden Modulators. Die fehlenden Zustandswerte des Quantisierungsfehlers ($e_2(k_2+1)$, $e_2(k_2+2)$, ...) können rekursionsfrei aus der parallelisierten Anordnung abgeleitet werden, sie gehen nicht mehr in die Rekursionsschleife ein, die vom Ausgang des Multibit-Quantisierers 4* zum Addierer 1 führt. Der Quantisierungsfehler $e_2(k_2)$ wird zwecks Berechnung des zeitlich nachfolgenden Quantisierungsfehlerwertes $e_2(k_2+1)$ auf einen zwischen einem nachfolgenden Verzögerer 2' und einem Multibit-Quantisierer 4'* angeordneten Addierer 7 geführt. Außerdem wird das negierte Ausgangssignal $y(k_2+1)$ des Multibit-Quantisierers 4'* auf einen weiteren Addierer 8 gegeben, der daraus und aus dem Ausgangssignal des Addierers 7 das Fehlersignal $e_2(k_2+2)$ bildet. Dieser Vorgang wiederholt für alle zu berechnenden Zustandswerte des Quantisierungsfehlers $e_2(k_2+1)$ ... $e_2(k_2+\lambda-1)$.

Aus den Werten des Quantisierungsfehlers $e_2(k)$ sowie des Eingangssignals $x(k)$ kann durch eine Logik der Zahlenwert des Quantisierers 4 berechnet werden:

$$y(k) = e_2(k-1) + x(k) - e_2(k) \tag{4}$$

Als Anwendungsbeispiel wird in den nachfolgenden Figuren die Realisierung eines parallelisierten kaskadierten Sigma-Delta-Modulators 3. Ordnung mit Ausgangswerten von -4 ... +4 und einem Faktor $\lambda=16$ dargestellt. Jedes Teilsystem 1. Ordnung dieses parallelisierten kaskadierten Sigma-Delta-Modulators erzeugt 16 3-stufige (1.5 Bit-) Ausgangssignale. Die Anwendung der hier dargestellten Strukturen ist jedoch offensichtlicherweise nicht nur auf die Spezialfälle 1.5 Bit und $\lambda=16$ beschränkt.

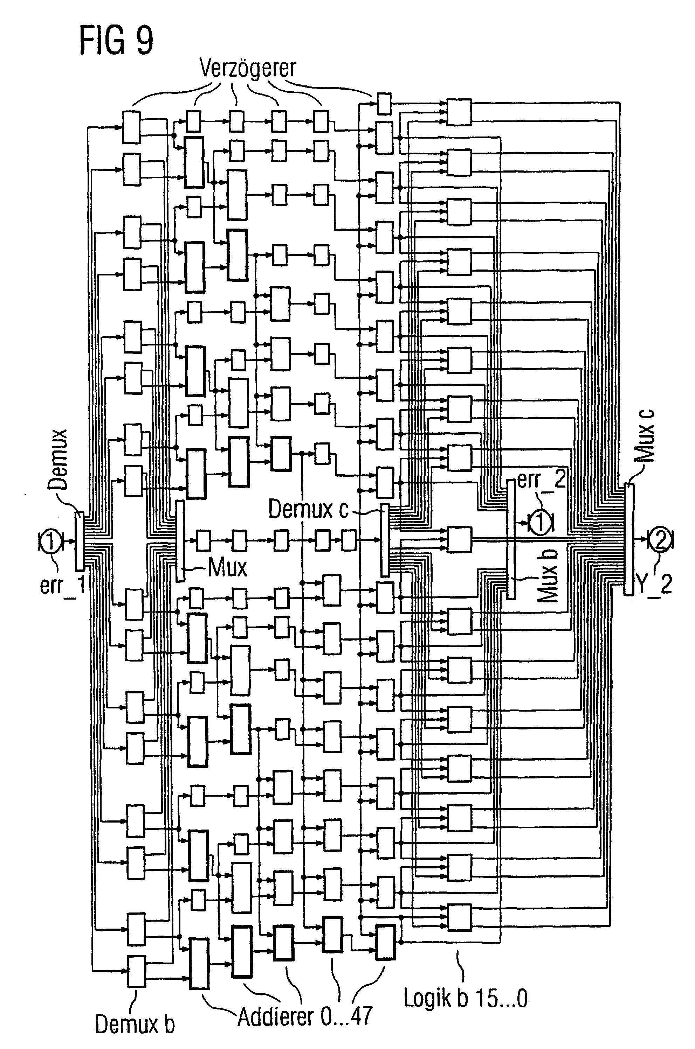

Ausgegangen wird bei der folgenden Darstellung von der in Fig. 9 dargestellten parallelen Realisierung eines Sigma-Delta-Modulators 1. Ordnung. Die 16 Eingangssignale dieses Beispiels sind in dem Signal err_1 zusammengefaßt. Durch den Demultiplexer Demux werden diese Signale getrennt und anschließend den einzelnen Demultiplexern Demux b 0..15 zugeführt. Diese Demultiplexer trennen ihre jeweiligen Eingangssignale auf in in zwei Teilsignale:

Ein Teilsignal (sgn) besteht aus MSB und 2. MSB und wird zeitverzögert über Mux, Verzögerungselemente und Demux c den Logikblöcken b 0..15 zugeführt.

Ein zweites Teilsignal (amp) besteht aus dem Eingangssignal der Demultiplexer Demux b, vermindert um das MSB und wird in ein Rechenwerk eingespeist.

Wie aus der folgenden Umformung zu entnehmem ist, wird mit der Aufspaltung eine Reduktion des 3-stufigen Sigma-Delta-Modulators 1. Ordnung auf ein Teilsignal sowie einen einfach zu realisierenden 2-stufigen Sigma-Delta-Modulator 1. Ordnung erreicht:

Sei das Eingangssignal ohne Einschränkung der Allgemeinheit auf den Zahlenbereich $-1 \leq x(k) < 1$ normiert. Dann kann $x(k)$ folgendermaßen dargestellt werden:

$$x(k) = amp(k) + s(k), \tag{5}$$

wobei

$$s(k) \in [-1,0] \tag{6}$$

und

$$0 \leq amp(k) < 1 \tag{7}$$

gilt. Die Gleichung eines 1.5-Bit Quantisierers

$$y(k) = \begin{cases} 1 & wenn & e(k-1) + x(k) \geq 0.5 \\ -1 & wenn & e(k-1) + x(k) < -0.5 \\ 0 & sonst \end{cases} \tag{8}$$

kann also umgeformt werden in:

$$y(k) = \begin{cases} 1 & wenn & e(k-1) + amp(k) + s(k) \geq 0.5 \\ -1 & wenn & e(k-1) + amp(k) + s(k) < -0.5 \\ 0 & sonst \end{cases} \qquad (9)$$

Der Quantisierungsfehler $e(k)$ des 1.5 Bit Sigma-Delta-Modulators 1. Ordnung ist dabei auf den Wertebereich $-0.5 \leq e(k) < 0.5$ beschränkt. Da nur $s(k)$ ein Überschreiten der Schwelle -0.5 bewirken kann, folgt:

$$y(k) = s(k) + \begin{cases} 1 & wenn & e(k-1) + amp(k) \geq 0.5 \\ 0 & sonst \end{cases} \qquad (10)$$

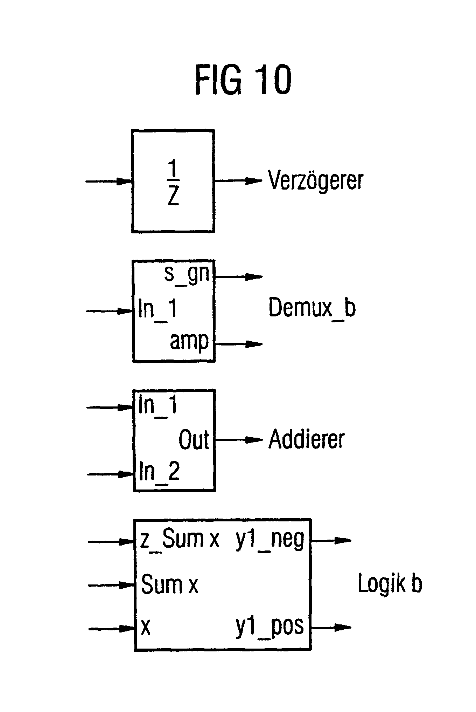

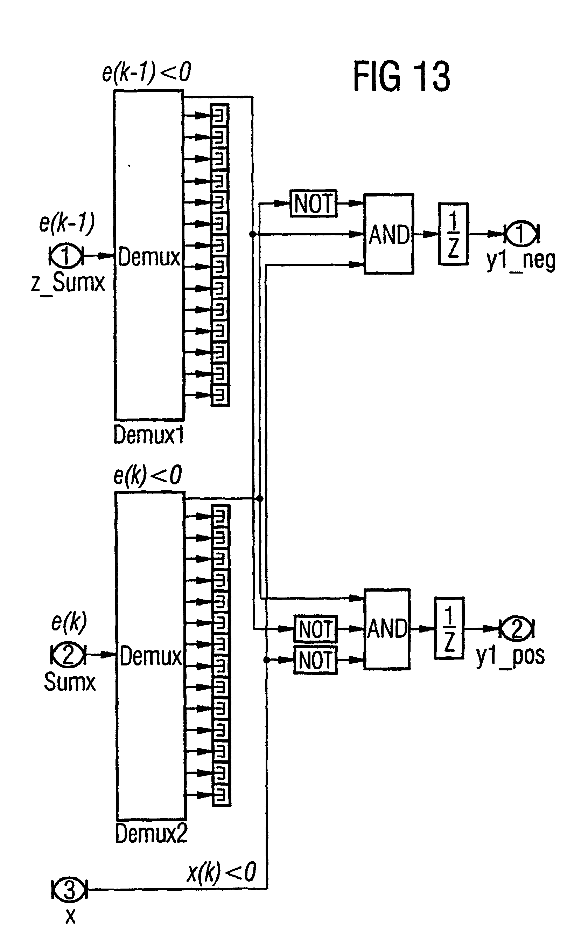

In Fig. 9 wird entsprechend Fig. 8 die parallele Realisierung des 1-Bit Sigma-Delta-Wandlerteils dargestellt. Das Integrate&Dump-Filters sowie des Multibit-Sigma-Delta-Modulators sind schraffiert hervorgehoben. Als Quantisierer wird die Überlaufcharakteristik der Zweierkomplementarithmetik ausgenutzt. Die nicht hervorgehobenen Strukturen berechnen die oben erwähnten Zustandswerte des Quantisierungsfehlers des Sigma-Delta-Modulators. Aus dem Quantisierungsfehler und der Kenntnis des Eingangssignals, das mittels Verzögerern vom Multiplexer MUX zum Demultiplexer DEMUX c (Bildmitte Fig. 10) weitergeleitet wird, werden die Werte des Quantisierers durch eine Logik, die in Fig. 13 und Fig. 14 näher dargestellt ist, ermittelt.

Die Belegungen der Anschlüsse der verwendeten Elemente: Verzögerer mit einem Ein- und einem Ausgang, Demux_b mit einem Ein- und zwei Ausgängen (In_1, s gn, amp), Addierer mit zwei Eingängen und einem Ausgang (In_1, In_2, Out), Logik b mit drei Eingängen und zwei Ausgängen (z_Sum x, Sum x, x, y1_neg, y2_pos) aus Fig. 9 sind in Fig. 10 näher dargestellt.

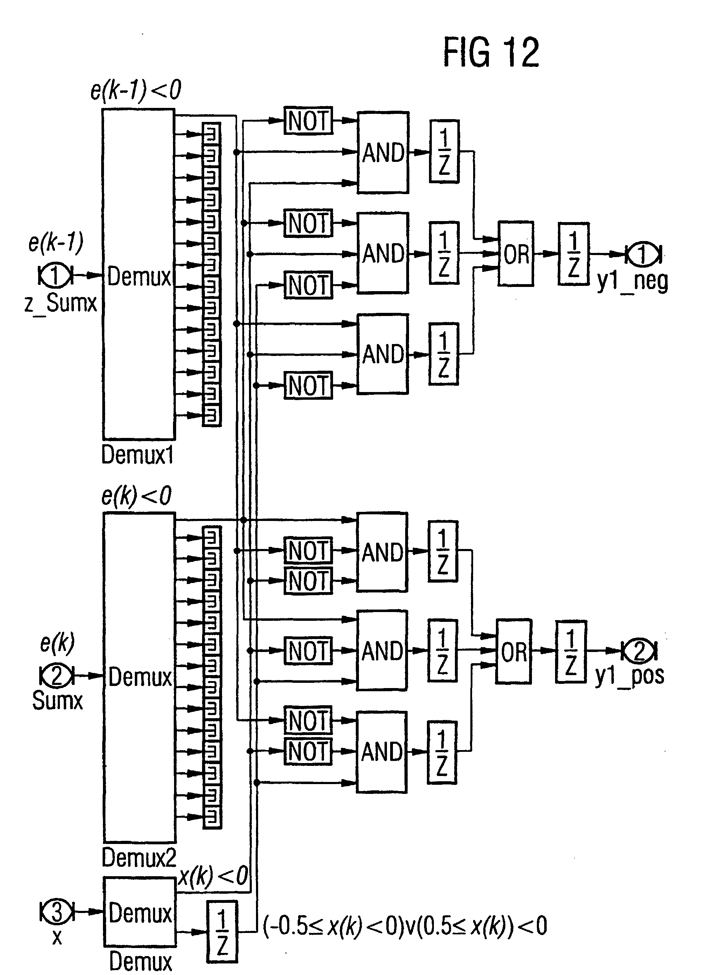

- Der in Fig. 9 verwendete Verzögerer hält den Wert seines Eingangssignals eine Zeiteinheit bei.
- Die Funktion von Demux b wurde bereits oben dargestellt: Ein Teilsignal (s gn) besteht aus MSB (Most Significant Bit) und 2. MSB und wird zeitverzögert über Mux, Verzögerungselemente und Demux c den Logikblöcken b 0..15 zugeführt. Ein zweites Teilsignal (amp) besteht aus dem Eingangssignal der Demultiplexer Demux b, vermindert um das MSB und wird in ein Rechenwerk eingespeist.
- Es wird ein wrappender Addierer mit $L-1$ Stufen verwendet.
- Die Logik b bildet die Funktion der Gleichung 4 nach. Sie ist in den Fig. 12 und 13 nochmals genauer dargestellt.

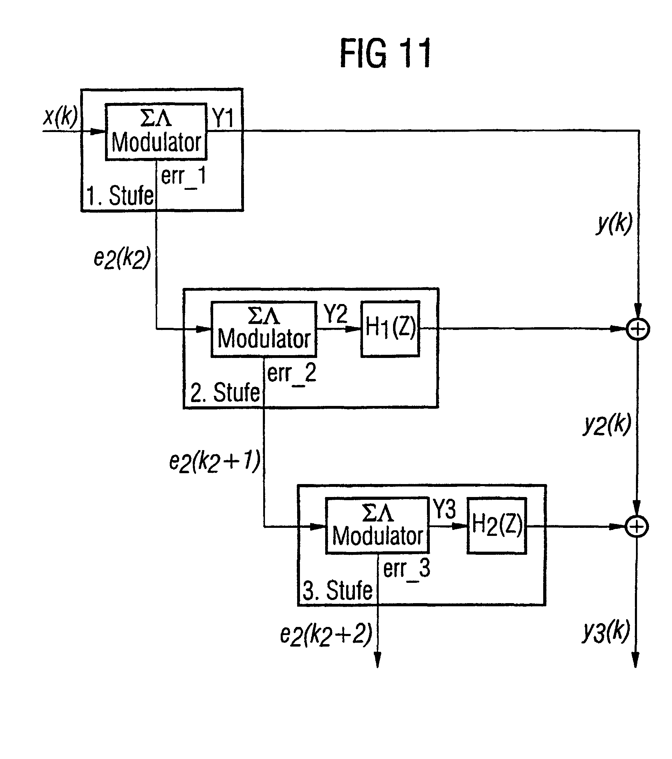

Fig. 11 zeigt das Gesamtmodell, in welchem 3 Stufen eines parallelisierten Sigma-Delta-Modulators 1. Ordnung zu einem Sigma-Delta-Modulator 3. Ordnung kaskadiert sind. Die drei Kaskaden sind untereinander dargestellt. Das System ähnelt einem System kaskadier Sigma-Delta Modulatoren ohne Parallelisierung. Das digitale Eingangssignals $x(k)$ wird auf die erste Stufe - ein Sigma-Delta-Wandler 1. Ordnung in paralleler Realisierung nach Fig. 9 - geführt, welcher das von dem Interpolationsfilter abgegebene digitale Eingangssignal in einen digitalen parallelen m-Bit Datenstrom $Y1$ am Ausgang umwandelt ($m \geq 1$). Das Ausgangsfehlersignal $e2(k_2)$ vom Ausgang err_1 des ersten Sigma-Delta-Modulators wird analog zu Fig. 8 und Fig. 9 der zweiten Kaskade (mittlere Darstellung in Fig. 11) zugeführt und dort in gleicher Weise verarbeitet usw.

Die Ausgangssignale vom Ausgang Y2 werden durch das FIR-Filter :

$$H_1(z) = 1 - z^{-1} \qquad (11)$$

und vom Ausgang Y3 durch das FIR-Filter:

$$H_2(z) = (1 - z^{-1})^2 \qquad (12)$$

gefiltert und zu dem Ausgangssignal des Sigma-Delta-Wandlers 3. Ordnung $y_3(k)$ kombiniert.

Für die erste Stufe des Sigma-Delta-Modulators aus Fig. 9 bzw. Fig. 11 zeigt Fig. 12 den inneren Aufbau eines Logik b-Elementes im einzelnen. Es wird hierbei die Funktion der Gleichung (4) realisiert. Das Ausgangssignal des Quantisierers 4 besitzt nur die drei Zustände -1, 0, 1. Um eine Identifikation des jeweiligen Zustandes durchzuführen, ist es nicht notwendig, exakt die Addition/Subtraktion auszuführen. Vielmehr reicht es, Aussagen darüber zu treffen, in welchem Zahlenbereich $e_2(k)$, $e_2(k\text{-}1)$ oder $x(k)$ liegt:

$$y(k) = \begin{cases} -1 & \textit{wenn} \quad ((e(k) \geq 0) \wedge (e(k-1) < 0) \wedge (x(k) < 0)) \\ & \qquad \vee ((e(k) \geq 0) \wedge (x(k) < -0.5)) \\ & \qquad \vee ((e(k-1) < 0) \wedge (x(k) < -0.5)) \\ 1 & \textit{wenn} \quad ((e(k) < 0) \wedge (e(k-1) \geq 0) \wedge (x(k) \geq 0)) \\ & \qquad \vee ((e(k) < 0) \wedge (x(k) \geq -0.5)) \qquad\qquad (13) \\ & \qquad \vee ((e(k-1) \geq 0) \wedge (x(k) \geq -0.5)) \\ 0 \end{cases}$$

Für die zweite und folgenden Stufen des Sigma-Delta-Modulators aus Fig. 11 zeigt Fig. 13 den inneren Aufbau eines Logik b-Elementes im einzelnen. Das Fehlersignal aus den vorhergehenden Stufen ist auf den Bereich $-0.5 \leq e(k) < 0.5$ beschränkt, so daß einige Logikverknüpfungen aus Gleichung 13 und Fig. 12 nicht notwendig sind.

**Patentansprüche**

1. Sigma-Delta-Modulator zur Wandlung eines digitalen Eingangssignals (x(k)) in ein quantisiertes Ausgangssignal (y(k2)) mit Hilfe eines Sigma-Delta-Modulators erster Ordnung, der einen ersten und einen zweiten Addierer (1,3) einen Verzögerer (2) und einen Entscheider (4) aufweist, wobei ein dem Sigma-Delta-Modulator erster Ordnung zugeführtes Modulatoreingangssignal über den ersten Addierer (1) und über den ihm nachgeschalteten Verzögerer (2) um eine Takteinheit verzögert einerseits am zweiten Addierer (3) und andererseits am Entscheider (4) angeschaltet ist und ein vom Entscheider (4) gebildetes Modulatorausgangssignal negiert an den zweiten Addierer (3) angeschaltet ist, der einen Quantisierungsfehlerwert (e2(k2)) bildet und dieser an den ersten Addierer gelangt, **dadurch gekennzeichnet,**

   - **dass** das digitale Eingangssignal (x(k)) an parallel zueinander angeordneten n Zweigen angeschaltet ist,
   - **dass** mit i=1 ein erster Zweig als Ausgangssignale das quantisierte Ausgangssignal (y(k2)) und den Quantisierungsfehlerwert (e2(k2)) des Sigma-Delta-Modulators erster Ordnung aufweist,
   - **dass** mit $1 < i \leq n$ jeder i-te Zweig einen Verzögerer (2'), einen mit einer Taktrate k2 getakteten Schalter zur zeitlichen Abtastung, einen ersten und einen zweiten Addierer (7,8) und einen Multibit-Quantisierer (4'*) aufweist, die derart angeordnet sind,

      - **dass** das digitale Eingangssignal (x(k)) über den Verzögerer (2') um i-1 Takteinheiten verzögert zum Schalter und von diesem zeitlich abgetastet zum ersten Addierer (7) gelangt,
      - **dass** ein vom ersten Addierer (7) gebildetes Summensignal einerseits an den Multibit-Quantisierer (4'*) zur Bildung eines um i-1 Takteinheiten verzögerten Ausgangssignals (y(k2+1),y(k2+2)) und andererseits an den zweiten Addierer (8) gelangt, und
      - **dass** das verzögerte Ausgangssignal des Multibit-Quantisierers (4'*) negiert an den zweiten Addierer angeschaltet ist, der durch Summation einen Quantisierungsfehlerwert (e2(k2+1), e2(k2+2)) des i-ten Zweiges bildet, und

      - **dass** mit $1 < i \leq n$ der Quantisierungsfehlerwert des i-1 ten Zweigs an den ersten Addierer des i-ten Zweiges zur Bildung des Summensignals angeschaltet ist.

**2.** Sigma-Delta-Modulator nach Anspruch 1,
**dadurch gekennzeichnet,**

- **dass** der erste Zweig den Sigma-Delta-Modulator erster Ordnung und eine ihm vorgeschaltete Serienschaltung aufweist, wobei die Serienschaltung aus einem Integrate&Dump-Filter (6) und aus einem mit der Taktrate k2 getakteten Schalter besteht, und das digitale Eingangssignal (x(k)) an den Integrate&Dump-Filter (6) angeschaltet ist,
- **dass** der Entscheider (4) des Sigma-Delta-Modulators erster Ordnung als Multibit-Quantisierer (4*) ausgeführt ist, und
- **dass** der vom Sigma-Delta-Modulator erster Ordnung gebildete Quantisierungsfehlerwert (e2(k2)) an den zweiten Zweig angeschaltet ist.

**3.** Sigma-Delta-Modulator nach Anspruch 2,
**dadurch gekennzeichnet,**
**dass** die Berechnung des Integrate&Dump-Filters (6), der Multi-Bit-Quantisierer (4*, 4'*..) und die Berechnung der Zustandswerte ($e_2(k_2+1)$, $e_2(k_2+2)$, ...) anhand eines binären Baums erfolgt.

**4.** Sigma-Delta-Modulator nach einem der Ansprüche 1 bis 3, **dadurch gekennzeichnet,**
**dass** das quantisierte Ausgangssignal (*y(k)*) mit Hilfe einer Logik aus den Quantsierungsfehlerwerten ($e_2(k)$) sowie aus dem Eingangssignal (*x(k)*) berechenbar ist.

**5.** Sigma-Delta-Modulator nach einem der vorhergehenden Ansprüche, **dadurch gekennzeichnet, dass** in einem parallelisiert aufgebauten Sigma-Delta-Modulator erster Ordnung unterabgetastet Quantisierungsfehlerwerte (e2(k2+1),e2(k2+2),...) berechnet werden, die mit den Quantisierungsfehlerwerten eines nicht parallelisierten auf hoher Abtastrate berechneten Sigma-Delta-Modulators übereinstimmen.

**6.** Sigma-Delta-Modulator höherer Ordnung mit einem Sigma-Delta-Modulator nach einem der vorhergehenden Ansprüche, **dadurch gekennzeichnet,**
**dass** mehrere Sigma-Delta-Modulatoren in Stufen kaskadiert angeordnet sind.

**Claims**

**1.** Sigma-delta modulator for converting a digital input signal (x(k)) into a quantized output signal (y(k2)) with the aid of a first order sigma-delta modulator which has a first and a second adder (1, 3), a delay circuit (2) and a discriminator (4), a modulator input signal fed to the first order sigma-delta modulator being connected, delayed by one clock unit via the first adder (1) and via the delay circuit (2) downstream of it, on the one hand, to the second adder (3) and, on the other hand, to the discriminator (4) and a modulator output signal formed by the discriminator (4) being connected in a negated fashion to the second adder (3), which forms a quantization error value (e2(k2)), and the latter passes to the first adder,
**characterized**

- **in that** the digital input signal (x(k)) is connected to n branches arranged in parallel with one another,
- **in that** with i=1 a first branch has as output signals the quantized output signal (y(k2)) and the quantization error value (e2(k2)) of the first order sigma-delta modulator,
- **in that** with 1<i≤n each ith branch has a delay circuit (2'), a switch, clocked at a clock-pulse rate k2, for temporal sampling, a first and a second adder (7, 8) and a multibit quantizer (4'*) which are arranged in such a way

    - that the digital input signal (x(k)) passes via the delay circuit (2') in a fashion delayed by i-1 clock units to the switch and from there in a temporally sampled fashion to the first adder (7),
    - that an aggregate signal formed by the first adder (7) on the one hand passes to the multibit quantizer (4'*) for the purpose of forming an output signal (y(k2+1), y(k2+2)) delayed by i-1 clock units, and on the other hand to the second adder (8), and
    - **in that** the delayed output signal of the multibit quantizer (4'*) is connected in a negated fashion to the second adder, which forms a quantization error value (e2(k2+1), e2(k2+2)) of the ith branch by summation, and

    - **in that** with 1<i≤n the quantization error value of the i-1th branch is connected to the first adder of the ith branch for the purpose of forming the aggregate signal.

2. Sigma-delta modulator according to Claim 1, **characterized**

   - **in that** the first branch has the first order sigma-delta modulator and a series circuit connected upstream of it, the series circuit comprising an integrate&dump filter (6) and a switch clocked at the clock-pulse rate k2, and the digital input signal (x(k)) is connected to the integrate&dump filter (6),
   - **in that** the discriminator (4) of the first order sigma-delta modulator is designed as a multibit quantizer (4*), and
   - **in that** the quantization error value (e2(k2)) formed by the first order sigma-delta modulator is connected to the second branch.

3. Sigma-delta modulator according to Claim 2, **characterized in that** the calculation of the integrate&dump filter (6) and the multibit quantizers (4*, 4'*..), and the calculation of the state values ($e_2(k_2+1)$, $e_2(k_2+2)$, ...) is performed with the aid of a binary tree.

4. Sigma-delta modulator according to one of Claims 1 to 3, **characterized in that** the quantized output signal (y(k)) can be calculated with the aid of a logic circuit from the quantization error values ($e_2(k)$) and from the input signal (x(k)).

5. Sigma-delta modulator according to one of the preceding claims, **characterized in that** there are calculated in a first order sigma-delta modulator of parallelized design undersampled quantization error values (e2(k2+1), e2(k2+2),...) which correspond to the quantization error values of a non-parallelized sigma-delta modulator calculated at a higher clock-pulse rate.

6. Higher order sigma-delta modulator having a sigma-delta modulator according to one of the preceding claims, **characterized in that** the plurality of sigma-delta modulators are arranged cascaded in stages.


**Revendications**

1. Modulateur sigma-delta pour la conversion d'un signal numérique d'entrée (*x(k)*) en un signal de sortie *(y(k2))* quantifié à l'aide d'un modulateur sigma-delta d'ordre 1 qui présente un premier et un deuxième additionneur (1, 3), un retardeur (2) et un discriminateur (4), un signal d'entrée de modulateur apporté au modulateur sigma-delta d'ordre 1 étant appliqué par l'intermédiaire du premier additionneur (1) et après avoir été retardé d'une unité d'horloge par l'intermédiaire du retardeur (2) raccordé en aval de l'additionneur d'une part au deuxième additionneur (3) et d'autre part au discriminateur (4), et un signal de sortie de modulateur formé par le discriminateur (4) est appliqué avec un signe opposé sur le deuxième additionneur (3) qui forme une valeur d'erreur de quantification *(e2(k2))*, cette valeur étant appliquée au premier additionneur,
   **caractérisé en ce que**

   - le signal numérique d'entrée (*x(k)*) est appliqué sur n branches disposées parallèlement les unes aux autres,
   - pour i=1, une première branche présente comme signaux de sortie le signal de sortie *(y(k2))* quantifié et la valeur de l'erreur de quantification *(e2(k2))* du modulateur sigma-delta d'ordre 1,
   - pour 1<i≤n, chaque branche i présente un retardeur (2'), un commutateur cadencé à une cadence d'horloge k2, pour l'échantillonnage dans le temps, un premier et un deuxième additionneur (7, 8) et un quantifieur multibits (4'*) qui sont disposés de telle sorte que

     - le signal numérique d'entrée (*x(k)*) est transféré au commutateur après avoir été retardé de i-1 unités d'horloge par le retardeur (2') et au premier additionneur (7) après avoir été échantillonné dans le temps par ce commutateur,
     - un signal de somme formé par le premier additionneur (7) est transféré d'une part au quantifieur multibits (4'*) pour la formation d'un signal de sortie *(y(k2+1), y(k2+2))* retardé de i-1 unités d'horloge et d'autre part au deuxième additionneur (8), et
     - après inversion de son signe, le signal de sortie retardé du quantifieur multibits (4'*) est appliqué sur le deuxième additionneur qui forme par sommation une valeur d'erreur de quantification *(e2(k2+1), e2(k2+2))* de la branche i, et

   - pour 1<i≤n, la valeur de l'erreur de quantification de la branche i-1 est appliquée au premier additionneur de la branche i pour la formation du signal de somme.

**2.** Modulateur sigma-delta selon la revendication 1, **caractérisé en ce que**

- la première branche présente le modulateur sigma-delta d'ordre 1 et un circuit série raccordé en amont, le circuit série étant constitué d'un filtre à intégration et élimination (6) et d'un commutateur cadencé à la cadence d'horloge k2, le signal numérique d'entrée ($x(k)$) étant appliqué sur le filtre à intégration et élimination (6),
- le discriminateur (4) du modulateur sigma-delta d'ordre 1 est configuré comme quantifieur multibits (4*), et
- la valeur de l'erreur de quantification (e2(k2)) formée par le modulateur sigma-delta d'ordre 1 est appliquée sur la deuxième branche.

**3.** Modulateur sigma-delta selon la revendication 2, **caractérisé en ce que** le calcul du filtre à intégration et élimination (6), des quantifieurs multibits (4*, 4'*, ...) et le calcul des valeurs d'état *($e_2(k_2+1)$, $e_2(k_2+2)$, ...)* s'effectue à l'aide d'un arbre binaire.

**4.** Modulateur sigma-delta selon l'une des revendications 1 à 3, **caractérisé en ce que** le signal de sortie quantifié ($y(k)$) peut être calculé à l'aide d'une logique à partir des valeurs de l'erreur de quantification *($e_2(k)$)* ainsi que du signal d'entrée ($x(k)$).

**5.** Modulateur sigma-delta selon l'une des revendications précédentes, **caractérisé en ce que** dans un modulateur sigma-delta d'ordre 1 à structure parallélisée, des valeurs sous-échantillonnées de l'erreur de quantification (*e2 (k2+1), e2(k2+2),* ...) sont calculées et correspondent aux valeurs d'erreur de quantification d'un modulateur sigma-delta non parallélisé calculé pour un taux d'échantillonnage élevé.

**6.** Modulateur sigma-delta d'ordre supérieur, qui présente un modulateur sigma-delta selon l'une des revendications précédentes, **caractérisé en ce que** plusieurs modulateurs sigma-delta sont disposés en cascade d'étages.

# FIG 1

Stand der Technik

# FIG 2

Stand der Technik

# FIG 3

## FIG 4

$x(k)$ → FIR1 (5a) → ⊕ (3, −) → ⊕ (1) → $z-\lambda$ (2) → $\tilde{x}(k)$ → ⎍ (4) → $y(k)$

$e2(k)$ — FIR2 (5b)

## FIG 5

$x(k)$ → FIR1 (5a) → ⊕ (1) → $z-\lambda$ (2) → $\tilde{x}(k)$ → ⎍ (4) → $y(k)$

$e2(k)$ — ⊕ (3, −) — FIR2 (5b)

## FIG 6

$x(k)$ → FIR1 (5a) → ⊕ (1) → $z-\lambda$ (2) → $\tilde{x}(k)$ → ▥ (4*) → $y(k)$

$e2(k)$ — ⊕ (3, −)

# FIG 7

# FIG 8

# FIG 9

Verzögerer

Demux

err_1

Mux

Demux b

Addierer 0...47

Demux c

Logik b 15...0

err_2

Mux b

Mux c

Y_2

# FIG 10

$$\frac{1}{Z}$$ → Verzögerer

s_gn →
In_1 → amp → Demux_b

In_1
Out → Addierer
In_2

z_Sum x   y1_neg →
Sum x → Logik b
x   y1_pos →

# FIG 11

# FIG 12

EP 1 224 739 B1

# FIG 13

18